# EUROPÄISCHE PATENTSCHRIFT

(11) **EP 2 109 872 B1**
(45) Veröffentlichungstag und Bekanntmachung des Hinweises auf die Patenterteilung: **13.12.2017**
(21) Anmeldenummer: 08701323.1
(22) Anmeldetag: 09.01.2008
(51) Int. Cl.: H01H 50/08, H01H 50/54

(54) **ERFASSUNGSEINRICHTUNG ZUM ERFASSEN DES SCHALTZUSTANDS EINES ELEKTROMAGNETISCHEN SCHALTGERÄTS**
RECORDING DEVICE FOR RECORDING THE SWITCH STATE OF AN ELECTROMAGNETIC SWITCH DEVICE
DISPOSITIF DE DÉTECTION DESTINÉ À LA DÉTECTION DE L'ÉTAT DE COMMUTATION D'UN COMMUTATEUR ÉLECTROMAGNÉTIQUE

(30) Priorität: 15.01.2007 DE 102007002176
(43) Veröffentlichungstag der Anmeldung: 21.10.2009
(73) Patentinhaber: Siemens Aktiengesellschaft, 80333 München (DE)
(72) Erfinder: KEIL, Rainer, 90451 Nürnberg (DE); KRAUS, Helmut, 92245 Kümmersbruck (DE); LANGEN, Stefan, 92245 Kümmersbruck (DE); SCHATZ, Wolfgang, 92224 Amberg (DE)
(86) Internationale Anmeldenummer: PCT/EP2008/050157
(87) Internationale Veröffentlichungsnummer: WO 2008/087074

(56) Entgegenhaltungen:
- EP-A- 1 246 218
- WO-A-92/06483
- WO-A-98/05052
- DE-A1- 3 117 914
- DE-A1- 19 506 168
- DE-A1- 19 605 974
- DE-A1- 19 918 577
- DE-T2- 69 202 108

## Beschreibung

Die vorliegende Erfindung betrifft eine Erfassungseinrichtung zum Erfassen des Schaltzustands eines elektromagnetischen Schaltgeräts, mit folgenden Merkmalen:
- Sie weist ein Gehäuse auf, in dem ein Stößel beweglich gelagert ist.
- Der Stößel ist zwischen zwei mechanischen Endstellungen bewegbar, wobei die Endstellungen des Stößels mit dem Schaltzustand des elektromagnetischen Schaltgeräts korrespondieren.

Elektromagnetische Schaltgeräte im Sinne der vorliegenden Erfindung sind Schütze, Trennschalter, Leitungsrelais, Leistungsschalter usw.. Für derartige elektromagnetische Schaltgeräte - insbesondere für Schütze - ist es bei einer Vielzahl von Anwendungsfällen erforderlich, den tatsächlichen Schaltzustand des elektromagnetischen Schaltgeräts - im Gegensatz gegebenenfalls zu einem Ansteuerzustand des elektromagnetischen Schaltgeräts - zu erfassen, um ihn anderweitig auswerten zu können.

Im Stand der Technik erfolgt eine derartige Erfassung mittels einer Erfassungseinrichtung, wie sie obenstehend beschrieben ist. Hierbei ist im Gehäuse ein mechanischer Schaltkontakt angeordnet, der beim Überführen des Stößels von der einen in die andere Endstellung seinen Schaltzustand wechselt. Der Schaltkontakt wird über Leitungen mit einer Auswertungseinrichtung verbunden, so dass von der Auswertungseinrichtung die Schaltstellung des Schaltkontakts und damit der Schaltzustand des elektromagnetischen Schaltgeräts erfassbar ist. Meist ist die Erfassungseinrichtung eine eigene, vom elektromagnetischen Schaltgerät verschiedene Einrichtung (sogenannter Hilfsschalter).

Die Vorgehensweise des Standes der Technik funktioniert in der Regel bereits recht gut. Sie ist jedoch verbesserungsfähig. Insbesondere kann die Zuverlässigkeit der Erfassungseinrichtung erhöht werden.

Dazu offenbrat die DE 692 02 108 T2 eine Erfassungseinrichtung zum Erfassen des Schaltzustands eines elektromagnetischen Schaltgeräts, wobei sie ein Gehäuse aufweist, in welchem ein Stößel gelagert ist, wobei der Stößel zwischen zwei mechanischen Endstellungen bewegbar ist, wobei die Endstellung des Stößels mit dem Schaltzustand des elektromagnetischen Schaltgeräts korrespondieren. Im Gehäuse ist eine Sensoreinrichtung angeordnet, von der erfassbar ist, in welcher der Endstellungen sich der Stößel befindet, und von der ein hiermit korrespondierendes elektrisches Signal abgebbar ist. Die Sensoreinrichtung ist derart ausgebildet, dass die Stellung des Stößels von ihr erfassbar ist, ohne den Stößel zu berühren.

Die Aufgabe der vorliegenden Erfindung besteht darin, eine Erfassungseinrichtung der eingangs beschriebenen Art derart weiter zu entwickeln, dass sie mit erhöhter Zuverlässigkeit arbeitet.

Die Aufgabe wird durch eine Erfassungseinrichtung der eingangs beschriebenen Art gelöst, die zusätzlich folgende Merkmale aufweist:
- Im Gehäuse ist eine Sensoreinrichtung angeordnet, von der erfassbar ist, in welcher der Endstellungen sich der Stößel befindet, und von der ein hiermit korrespondierendes elektrisches Signal abgebbar ist.
- Die Sensoreinrichtung ist derart ausgebildet, dass die Stellung des Stößels von ihr erfassbar ist, ohne den Stößel zu berühren.

Durch die erfindungsgemäße Ausgestaltung der Erfassungseinrichtung wird insbesondere erreicht, dass die Sensoreinrichtung nicht den ruckartigen, harten Bewegungen des Stößels ausgesetzt ist. Sie kann damit insbesondere kleiner und leichter als im Stand der Technik ausgebildet sein und schneller arbeiten.

Es ist möglich, dass am Gehäuse ein Abgreifanschluss angeordnet ist, der von außerhalb des Gehäuses zugänglich ist und über den das von der Sensoreinrichtung abgegebene elektrische Signal als solches unmittelbar abgreifbar ist. Bevorzugt ist jedoch, dass im Gehäuse eine Aufbereitungsschaltung angeordnet ist, die das von der Sensoreinrichtung abgegebene elektrische Signal in eine Nachricht aufbereitet und die Nachricht über einen Kommunikationsanschluss ausgibt. Diese letztgenannte Ausgestaltung kann alternativ oder zusätzlich zur unmittelbaren Abgreifbarkeit des von der Sensoreinrichtung abgegebenen elektrischen Signals realisiert sein.

Vorzugsweise ist im Gehäuse eine Leiterplatte angeordnet, auf der die Sensoreinrichtung angeordnet ist. Dadurch ergibt sich eine fertigungstechnisch einfachere Herstellbarkeit der Erfassungseinrichtung.

Vorzugsweise ist die Sensoreinrichtung als elektronische Sensoreinrichtung ausgebildet, die keine beweglichen Teile aufweist. Durch diese Ausgestaltung sind zum einen die Zuverlässigkeit und die Lebensdauer der Sensoreinrichtung erhöhbar, zum anderen kann die Sensoreinrichtung integriert und miniaturisiert werden.

Es ist möglich, dass das Gehäuse und der Stößel derart aufeinander abgestimmt sind, dass von außerhalb des Gehäuses optisch erkennbar ist, in welcher der Endstellungen sich der Stößel befindet. In diesem Fall ist der Schaltzustand des elektromagnetischen Schaltgeräts nicht nur auf elektrischem bzw. elektronischem Weg nach außen meldbar, sondern auch direkt von außen von einem Menschen erkennbar.

Es ist möglich, dass die Erfassungseinrichtung Bestandteil des elektromagnetischen Schaltgeräts als solchem ist. In der Regel hingegen ist das Gehäuse der Erfassungseinrichtung ein vom Gehäuse des elektromagnetischen Schaltgeräts verschiedenes Gehäuse und ist der Stößel der Erfassungseinrichtung ein vom Stößel des elektromagnetischen Schaltgeräts verschiedener Stößel. In diesem Fall ist das Gehäuse der Erfassungseinrichtung am Gehäuse des elektromagnetischen Schaltgeräts fixierbar. Der Stößel der Erfassungseinrichtung ist in diesem Fall mit dem Stößel des elektromagnetischen Schaltgeräts verbindbar, so dass der Stößel der Erfassungseinrichtung sich zusammen mit dem Stößel des elektromagnetischen Schaltgeräts bewegt.

Weitere Vorteile und Einzelheiten ergeben sich aus der nachfolgenden Beschreibung eines Ausführungsbeispiels in Verbindung mit den Zeichnungen.

Es zeigen in Prinzipdarstellung:
- FIG 1: schematisch den konstruktiven Aufbau eines elektromagnetischen Schaltgeräts und einer Erfassungseinrichtung und
- FIG 2: schematisch ein elektrisches Blockschaltbild der Erfassungseinrichtung.

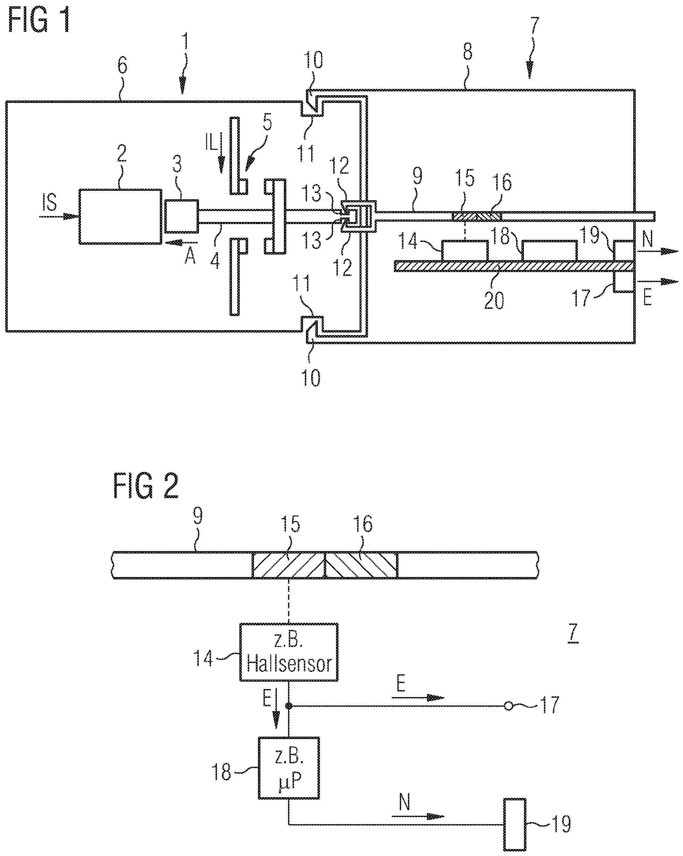

Gemäß FIG 1 ist ein elektromagnetisches Schaltgerät 1 als Schütz ausgebildet. Es weist eine Spule 2 auf, die mit einem Schaltstrom IS beaufschlagbar ist. Wenn die Spule 2 mit dem Schaltstrom IS beaufschlagt wird, zieht sie einen Anker 3 an. Dies ist in FIG 1 durch einen Pfeil A andeutet. Wird der Schaltstrom IS unterbrochen, bewegt sich der Anker 3 auf Grund einer rücktreibenden Federkraft von der Spule 2 weg.

Mit dem Anker 3 ist ein Stößel 4 verbunden. Zusammen mit dem Anker 3 wird daher auch der Stößel 4 von der Spule 2 angezogen. Auf Grund der Bewegung des Stößels 4 wird (mindestens) ein Lastkontakt 5 geschlossen, so dass ein Laststrom IL fließen kann. Umgekehrt wird beim Unterbrechen des Schaltstroms IS der Lastkontakt 5 wird wieder geöffnet.

In der Regel weist das elektromagnetische Schaltgerät 1 mehrere Lastkontakte 5 auf, beispielsweise drei, vier oder fünf Lastkontakte 5. Die Darstellung nur eines einzigen Lastkontakts 5 in FIG 1 dient lediglich der besseren Übersichtlichkeit.

Die in FIG 1 dargestellte Ausgestaltung des elektromagnetischen Schaltgeräts ist nicht die einzig möglich Ausgestaltung. Alternativ könnte das elektromagnetische Schaltgerät 1 beispielsweise als Leistungsschalter ausgebildet sein. In diesem Fall ist der Schaltstrom IS mit dem Laststrom IL identisch. Die Spule 2 zieht in diesem Fall den Anker 3 an, wenn der Laststrom IL zu groß wird. Auf Grund des Anziehens des Ankers 3 wird ein Schaltschloss freigegeben, das den Stößel 4 in eine Stellung bewegt, in welcher der Lastkontakt 5 geöffnet bleibt.

Unabhängig von der konkreten Ausgestaltung des elektromagnetischen Schaltgeräts 1 weist das elektromagnetische Schaltgerät 1 ein Gehäuse 6 auf, welches die anderen obenstehend erwähnten Elemente 2 bis 5 des elektromagnetischen Schaltgeräts 1 umgibt. Auch korrespondiert die Stellung des Stößels 4 unabhängig von der konkreten Ausgestaltung des elektromagnetischen Schaltgeräts 1 mit dem Schaltzustand des Lastkontakts 5 und damit dem Schaltzustand des elektromagnetischen Schaltgeräts 1.

Um den Schaltzustand des elektromagnetischen Schaltgeräts 1 erfassen zu können, ist eine Erfassungseinrichtung 7 vorhanden. Die Erfassungseinrichtung 7, die nachfolgend noch näher erläutert werden wird, kann ein Bestandteil des elektromagnetischen Schaltgeräts 1 sein. Gemäß FIG 1 ist sie jedoch als Aufsatzgerät zum Aufsetzen auf das elektromagnetische Schaltgerät 1 ausgebildet. Gemäß FIG 1 weist die Erfassungseinrichtung 7 daher ein Gehäuse 8 auf, das vom Gehäuse 6 des elektromagnetischen Schaltgeräts 1 verschieden ist. Weiterhin weist die Erfassungseinrichtung 7 einen Stößel 9 auf, der vom Stößel 4 des elektromagnetischen Schaltgeräts 1 verschieden ist.

Im vorliegenden Fall, in dem die Erfassungseinrichtung 7 als Aufsatzgerät ausgebildet ist, ist das Gehäuse 8 der Erfassungseinrichtung 7 am Gehäuse 6 des elektromagnetischen Schaltgeräts 1 fixierbar. In FIG 1 ist dies durch Rasthaken 10 angedeutet, die am Gehäuse 8 der Erfassungseinrichtung 7 angeordnet sind und mit Rastausnehmungen 11 zusammenwirken, die am Gehäuse 6 des elektromagnetischen Schaltgeräts 1 angeordnet sind. Die Fixierung der Erfassungseinrichtung 7 am elektromagnetischen Schaltgerät 1 muss jedoch nicht mittels einer Rastverbindung erfolgen. Es kann alternativ oder zusätzlich auf andere Weise fixiert sein, beispielsweise mittels Schraubverbindungen.

Der Stößel 9 der Erfassungseinrichtung 7 ist im Gehäuse 8 der Erfassungseinrichtung 7 beweglich gelagert. Der Stößel 9 der Erfassungseinrichtung 7 ist mit dem Stößel 4 des elektromagnetischen Schaltgeräts 1 verbindbar. Auch hier können beispielsweise am Stößel 9 der Erfassungseinrichtung 7 Rasthaken 12 angeordnet sein, die mit Rastausnehmungen 13 zusammenwirken, die am Stößel 4 des elektromagnetischen Schaltgeräts 1 angeordnet sind. Auch hier ist jedoch eine andere Art der Verbindung möglich. Entscheidend ist, dass der Stößel 9 der Erfassungseinrichtung 7 sich zusammen mit dem Stößel 4 des elektromagnetischen Schaltgeräts 1 bewegt.

Soweit das elektromagnetische Schaltgerät 1 und die Erfassungseinrichtung 7 bisher beschrieben wurden, entspricht der Aufbau dem aus dem Stand der Technik allgemein bekannten Aufbau. Insbesondere ist der Stößel 9 der Erfassungseinrichtung 7 zwischen zwei mechanischen Endstellungen bewegbar. Auf Grund der Verbindung des Stößels 9 der Erfassungseinrichtung 7 mit dem Stößel 4 des elektromagnetischen Schaltgeräts 1 korrespondieren die Endstellungen des Stößels 9 der Erfassungseinrichtung 7 mit dem Schaltzustand des elektromagnetischen Schaltgeräts 1.

Erfindungsgemäß ist jedoch im Gehäuse 8 der Erfassungseinrichtung 7 eine Sensoreinrichtung 14 angeordnet. Von der Sensoreinrichtung 14 ist erfassbar, in welcher der Endstellungen sich der Stößel 9 der Erfassungseinrichtung 7 befindet. Von der Sensoreinrichtung 14 ist ein elektrisches Signal E abgebbar, das mit der erfassten Endstellung korrespondiert. Die Sensoreinrichtung 14 ist hierbei derart ausgebildet, dass die Stellung des Stößels 9 der Erfassungseinrichtung 7 von ihr erfassbar ist, ohne den Stößel 9 der Erfassungseinrichtung 7 zu berühren.

Gemäß FIG 2 kann die Sensoreinrichtung 14 beispielsweise als Hallsensor realisiert sein. In diesem Fall müssen Abschnitte 15, 16 des Stößels 9 der Erfassungseinrichtung 7, die sich in je einer der Endstellungen des Stößels 9 der Erfassungseinrichtung 7 im Einwirkungsbereich der Sensoreinrichtung 14 befinden, magnetisch unterschiedlich ausgestaltet sein. Beispielsweise können die Abschnitte 15, 16 gegensinnig zueinander magnetisiert sein.

Im Falle der Ausgestaltung als Hallsensor detektiert die Sensoreinrichtung 14 das Magnetfeld. Es sind jedoch alternativ andere Ausgestaltungen denkbar. Beispielsweise kann die Sensoreinrichtung 14 als induktiver oder kapazitiver oder auf Ultraschall basierender Näherungsschalter ausgebildet sein. Wiederum alternativ kann die Sensoreinrichtung 14 als optische Erfassungseinrichtung ausgebildet sein, die auf Grund transmittierten oder reflektierten Lichtes erfasst, in welcher der Endstellungen sich der Stößel 9 der Erfassungseinrichtung 7 befindet. Selbstverständlich muss bei jeder dieser Ausgestaltungen der Stößel 9 der Erfassungseinrichtung 7 entsprechend ausgebildet sein.

Im Falle der obenstehend beschriebenen Ausgestaltungen der Sensoreinrichtung 14 ist die Sensoreinrichtung 14 als elektronische Sensoreinrichtung 14 ausgebildet. Sie weist in diesem Fall keine beweglichen Teile auf. Alternativ könnte die Sensoreinrichtung 14 jedoch auch bewegliche Teile aufweisen. Dies wäre beispielsweise der Fall, wenn die Sensoreinrichtung 14 als Reedrelais oder als anderweitig magnetomechanisch betätigtes Schaltelement ausgebildet ist.

Der erfasste Schaltzustand bzw. das hiermit korrespondierende elektrische Signal E soll in der Regel nach außen abgegeben werden. Im einfachsten Fall ist hierzu am Gehäuse 8 der Erfassungseinrichtung 7 ein Abgreifanschluss 17 angeordnet. Der Abgreifanschluss 17 ist in der Regel von außerhalb des Gehäuses 8 der Erfassungseinrichtung 7 zugänglich. Über den Abgreifanschluss 17 ist - siehe insbesondere FIG 2 - das elektrische Signal E unmittelbar und direkt als solches abgreifbar.

Alternativ oder zusätzlich zum Vorhandensein des Abgreifanschlusses 17 ist es möglich, dass im Gehäuse 8 der Erfassungsschaltung 7 eine Aufbereitungsschaltung 18 angeordnet ist. Die Aufbereitungsschaltung 18 ist mit der Sensoreinrichtung 14 verbunden. Sie bereitet das elektrische Signal E in eine Nachricht N auf und gibt die Nachricht N über einen Kommunikationsanschluss 19 aus. Der Kommunikationsanschluss 19 kann beispielsweise als Busanschluss, als Punkt-zu-Punkt-Anschluss oder als drahtlose Anbindung ausgebildet sein. Er ist vorzugsweise - analog zum Abgreifanschluss 17 - am Gehäuse 8 der Erfassungseinrichtung 7 angeordnet und von außerhalb des Gehäuses 8 der Erfassungseinrichtung 7 zugänglich.

Gemäß FIG 1 ist im Gehäuse 8 der Erfassungseinrichtung 7 eine Leiterplatte 20 angeordnet. Auf der Leiterplatte 20 sind die Bauelemente der Erfassungseinrichtung 7 angeordnet, also zumindest die Sensoreinrichtung 14. Soweit vorhanden, ist auch die Aufbereitungsschaltung 18 auf der Leiterplatte 20 angeordnet. Gegebenenfalls können auch der Abgreifanschluss 17 und/oder der Kommunikationsanschluss 19 auf der Leiterplatte 20 angeordnet sein.

Die elektrische Funktionalität der obenstehend beschriebenen Erfassungseinrichtung 7 ist vollauf zufriedenstellend. Zusätzlich ist es jedoch möglich, dass das Gehäuse 8 der Erfassungseinrichtung 7 und der Stößel 9 der Erfassungseinrichtung 7 derart aufeinander abgestimmt sind, dass von außerhalb des Gehäuses 8 der Erfassungseinrichtung 7 optisch erkennbar ist, in welcher der Endstellungen sich der Stößel 9 der Erfassungseinrichtung 7 befindet. Beispielsweise kann die Abstimmung derart sein, dass der Stößel 9 der Erfassungseinrichtung 7 derart dimensioniert und im Gehäuse 8 der Erfassungseinrichtung 7 gelagert ist, dass der Stößel 9 - siehe FIG 1 - aus dem Gehäuse 8 der Erfassungseinrichtung 7 herausragt, wenn der Lastkontakt 5 geöffnet ist. Alternativ oder zusätzlich könnte beispielsweise in das Gehäuse 8 der Erfassungseinrichtung 7 eine Öffnung oder ein Sichtfenster eingebracht sein, so dass in genau einer der Endstellungen des Stößels 9 der Erfassungseinrichtung 7 eine am Stößel 9 der Erfassungseinrichtung 7 angeordnete Markierung von außen sichtbar ist.

Die Abstimmung des Gehäuses 8 der Erfassungseinrichtung 7 mit dem Stößel 9 der Erfassungseinrichtung 7 ist vorzugsweise derart, dass auch dann optisch erkennbar ist, in welcher der Endstellungen sich der Stößel 9 der Erfassungseinrichtung 7 befindet, wenn das Gehäuse 8 der Erfassungseinrichtung 7 am Gehäuse 6 des elektromagnetischen Schaltgeräts 1 fixiert ist.

Die obige Beschreibung dient ausschließlich der Erläuterung der vorliegenden Erfindung. Der Schutzumfang der vorliegenden Erfindung soll hingegen ausschließlich durch die beigefügten Ansprüche bestimmt sein.

## Patentansprüche

1. Erfassungseinrichtung zum Erfassen des Schaltzustands eines elektromagnetischen Schaltgeräts (1), mit folgenden Merkmalen:
- Sie weist ein Gehäuse (8) auf, in dem ein Stößel (9) beweglich gelagert ist.
- Der Stößel (9) ist zwischen zwei mechanischen Endstellungen bewegbar, wobei die Endstellungen des Stößels (9) mit dem Schaltzustand des elektromagnetischen Schaltgeräts (1) korrespondieren.
- Im Gehäuse (8) ist eine Sensoreinrichtung (14) angeordnet, von der erfassbar ist, in welcher der Endstellungen sich der Stößel (9) befindet, und von der ein hiermit korrespondierendes elektrisches Signal (E) abgebbar ist.
- Die Sensoreinrichtung (14) ist derart ausgebildet, dass die Stellung des Stößels (9) von ihr erfassbar ist, ohne den Stößel (9) zu berühren, **dadurch gekennzeichnet, dass** im Gehäuse (8) eine Aufbereitungsschaltung (18) angeordnet ist, die das von der Sensoreinrichtung (14) abgegebene elektrische Signal (E) in eine Nachricht (N) aufbereitet und die Nachricht (N) über einen Kommunikationsanschluss (19) ausgibt, wobei das Gehäuse (8) und der Stößel (9) derart aufeinander abgestimmt sind, dass von außerhalb des Gehäuses (8) optisch erkennbar ist, in welcher der Endstellungen sich der Stößel (9) befindet und wobei das Gehäuse (8) der Erfassungseinrichtung ein vom Gehäuse (6) des elektromagnetischen Schaltgeräts (1) verschiedenes Gehäuse (8) ist und der Stößel (9) der Erfassungseinrichtung ein vom Stößel (4) des elektromagnetischen Schaltgeräts (1) verschiedener Stößel (9) ist, dass das Gehäuse (8) der Erfassungseinrichtung am Gehäuse (6) des elektromagnetischen Schaltgeräts (1) fixierbar ist und dass der Stößel (9) der Erfassungseinrichtung mit dem Stößel (4) des elektromagnetischen Schaltgeräts (1) verbindbar ist, so dass der Stößel (9) der Erfassungseinrichtung sich zusammen mit dem Stößel (4) des elektromagnetischen Schaltgeräts (1) bewegt.

2. Erfassungseinrichtung nach Anspruch 1,
**dadurch gekennzeichnet,**
**dass** am Gehäuse (8) ein Abgreifanschluss (17) angeordnet ist, der von außerhalb des Gehäuses (8) zugänglich ist und über den das von der Sensoreinrichtung (14) abgegebene elektrische Signal (E) als solches unmittelbar abgreifbar ist.

3. Erfassungseinrichtung nach Anspruch 1, oder 2,
**dadurch gekennzeichnet,**
**dass** im Gehäuse (8) eine Leiterplatte (20) angeordnet ist, auf der die Sensoreinrichtung (14) angeordnet ist.

4. Erfassungseinrichtung nach einem der obigen Ansprüche,
**dadurch gekennzeichnet,**
**dass** die Sensoreinrichtung (14) als elektronische Sensoreinrichtung (14) ausgebildet ist, die keine beweglichen Teile aufweist.

5. Erfassungseinrichtung nach Anspruch 1,
**dadurch gekennzeichnet,**
**dass** bei am Gehäuse (6) des elektromagnetischen Schaltgeräts (1) fixiertem Gehäuse (8) der Erfassungseinrichtung von außerhalb des Gehäuses (8) der Erfassungseinrichtung optisch erkennbar ist, in welcher der Endstellungen sich der Stößel (9) befindet.

## Claims

1. Detection apparatus for detecting the switching state of an electromagnetic switching device (1), the detection apparatus having the following features:
- It has a housing (8) in which a plunger (9) is movably mounted.
- The plunger (9) can be moved between two mechanical end positions, the end positions of the plunger (9) corresponding to the switching state of the electromagnetic switching device (1).
- A sensor apparatus (14) is disposed in the housing (8), said sensor apparatus (14) being able to detect in which of the end positions the plunger (9) is located and to emit an electrical signal (E) corresponding thereto.
- The sensor apparatus (14) is embodied such that it is able to detect the position of the plunger (9) without touching the plunger (9), **characterised in that** a conditioning circuit (18) is disposed in the housing (8) and conditions the electrical signal (E), which was emitted by the sensor apparatus (14), into a message (N) and outputs the message (N) via a communication interface (19), wherein the housing (8) and the plunger (9) are coordinated in such a way that it can be identified visually from outside the housing (8) in which of the end positions the plunger (9) is located and wherein the housing (8) of the detection apparatus is a different housing (8) from the housing (6) of the electromagnetic switching device (1) and the plunger (9) of the detection apparatus is a different plunger (9) from the plunger (4) of the electromagnetic switching device (1), that the housing (8) of the detection apparatus can be fixed to the housing (6) of the electromagnetic switching device (1), and that the plunger (9) of the detection apparatus can be connected to the plunger (4) of the electromagnetic switching device (1), such that the plunger (9) of the detection apparatus moves together with the plunger (4) of the electromagnetic switching device (1).

2. Detection apparatus according to claim 1,
**characterised in that**
a pickup interface (17) is disposed on the housing (8) and is accessible from outside the housing (8) and allows the electrical signal (E) that is emitted by the sensor apparatus (14) to be immediately picked up as such.

3. Detection apparatus according to claim 1, or 2,
**characterised in that**
a printed circuit board (20) is disposed in the housing (8) and the sensor apparatus (14) is disposed thereon.

4. Detection apparatus according to one of the preceding claims,
**characterised in that**
the sensor apparatus (14) is embodied as an electronic sensor apparatus (14) which has no moving parts.

5. Detection apparatus according to claim 1,
**characterised in that**
when the housing (8) of the detection apparatus is fixed to the housing (6) of the electromagnetic switching device (1) it can be identified visually from outside the housing (8) of the detection apparatus in which of the end positions the plunger (9) is located.

## Revendications

1. Dispositif de détection destiné à la détection de l'état de commutation d'un commutateur électromagnétique (1), comportant les caractéristiques suivantes :
- il comporte un boîtier (8) dans lequel un poussoir (9) est logé mobile ;
- le poussoir (9) est mobile entre deux fins de course mécaniques, les fins de course du poussoir (9) correspondant à l'état de commutation du commutateur électromagnétique (1) ;
- dans le boîtier (8) se trouve un dispositif capteur (14) qui peut détecter dans laquelle des fins de course se trouve le poussoir (9) et qui peut émettre un signal électrique (E) qui y correspond ;
- le dispositif capteur (14) est conçu de telle sorte qu'il peut détecter la position du poussoir (9) sans entrer en contact avec le poussoir (9), **caractérisé en ce qu'**est agencé, dans le boîtier (8), un circuit de traitement (18) qui convertit le signal électrique (E) émis par le dispositif capteur (14) en un message (N) et émet le message (N) via un port de communication (19), le boîtier (8) et le poussoir (9) étant adaptés entre eux de manière telle qu'il est possible de reconnaître optiquement, depuis l'extérieur du boîtier (8), dans laquelle des fins de course le poussoir (9) se trouve, et le boîtier (8) du dispositif de détection étant un boîtier (8) différent du boîtier (6) du commutateur électromagnétique (1) et le poussoir (9) du dispositif de détection étant un poussoir (9) différent du poussoir (4) du commutateur électromagnétique (1), que le boîtier (8) du dispositif de détection peut être fixé sur le boîtier (6) du commutateur électromagnétique (1) et que le poussoir (9) du dispositif de détection peut être relié au poussoir (4) du commutateur électromagnétique (1), de sorte que le poussoir (9) du dispositif de détection se déplace ensemble avec le poussoir (4) du commutateur électromagnétique (1).

2. Dispositif de détection selon la revendication 1, **caractérisé en ce qu'**est agencé, sur le boîtier (8), un port de prélèvement (17) qui est accessible depuis l'extérieur du boîtier (8) et via lequel peut être directement prélevé, en tant que tel, le signal électrique (E) émis par le dispositif capteur (14).

3. Dispositif de détection selon la revendication 1 ou 2, **caractérisé en ce qu'**est agencé, dans le boîtier (8), un circuit imprimé (20) sur lequel se trouve le dispositif capteur (14).

4. Dispositif de détection selon l'une des revendications précédentes, **caractérisé en ce que** le dispositif capteur (14) est réalisé en tant que dispositif capteur électronique (14) ne présentant pas de pièces mobiles.

5. Dispositif de détection selon la revendication 1, **caractérisé en ce que**, le boîtier (8) du dispositif de détection étant fixé au boîtier (6) du commutateur électromagnétique (1), il est possible de reconnaître optiquement, depuis l'extérieur du boîtier (8) du dispositif de détection, dans laquelle des fins de course le poussoir (9) se trouve.
